# EUROPÄISCHE PATENTANMELDUNG

(11) **EP 2 063 559 A2**
(43) Veröffentlichungstag der Anmeldung: **27.05.2009**
(21) Anmeldenummer: 08105440.5
(22) Anmeldetag: 26.09.2008
(51) Int. Cl.: H04H 60/74, H04H 60/51, H04H 60/61, H04H 60/13

(54) **Verfahren zum Einstellen einer Empfangsfrequenz für einen mobilen Rundfunkempfänger**

(30) Priorität: 26.11.2007 DE 102007056914
(71) Anmelder: ROBERT BOSCH GMBH, 70442 Stuttgart (DE)
(72) Erfinder: Groeger, Klaus-Erwin, 31199 Diekholzen (DE); Rosenbaum, Thomas, 71282 Hemmingen (DE)

(57) **Zusammenfassung**

Die Erfindung betrifft ein Verfahren zum Einstellen eines Rundfunkprogramms für ein sich bewegendes Rundfunkempfangsgerät (2), bei dem das Rundfunkprogramm ereignisabhängig in Abhängigkeit einer Situation aus der Vergangenheit automatisch eingestellt wird. Außerdem betrifft die Erfindung ein Rundfunkempfangsgerät (2), zum Empfangen eines Rundfunkprogramms, das dazu ausgebildet ist, das Rundfunkprogramm ereignisabhängig in Abhängigkeit einer Situation aus der Vergangenheit automatisch einzustellen, ein Computerprogramm und ein Computerprogrammprodukt.

## Beschreibung

Die Erfindung betrifft ein Verfahren zum Einstellen eines Rundfunkprogramms, ein Rundfunkempfangsgerät, ein Computerprogramm und ein Computerprogrammprodukt.

### Stand der Technik

Bei Fahrten mit dem PKW ist üblicherweise ein Radio zum Empfangen eines von einem Rundfunksender bereitgestellten Rundfunkprogramms mit Verkehrsfunk eingeschaltet. Wenn mit dem PKW jedoch der Sendebereich des bevorzugt gehörten Programms verlassen wird und alle Bemühungen, eine qualitativ bessere rauschfreie Frequenz des Programms zu finden, ausgeschöpft sind, ist es in der Regel erforderlich, ein neues Programm zu suchen. Bekannte Vorgehensweisen sehen dabei die Suche nach starken VF- (Verkehrsfunk-) Sendern vor, derartige Verkehrsfunk-Sender werden bspw. im Falle des RDS (Radio Data System bzw. Radiodatensystem) mit dem sog. TP bzw. Traffic Program-Bit gekennzeichnet. Ein Suchlauf oder automatischer Wechsel kann auch zu Programmen mit gleicher PTY (program type) -Kennung erfolgen, so dass ein Sender, der ein Rundfunkprogramm mit demselben Programminhalt, bspw. Nachrichten, Sport, Klassik, Popmusik, usw., wie des vorher eingestellten Programms gesucht wird. Es kann auch die Suche nach einem verwandten Rundfunkprogramm, z.B. NDR2, - NDR1 oder N-Joy des norddeutschen Rundfunks, auf das bspw. über EON bzw. enhanced other networks im RDS-Signal des aktuellen Rundfunkprogramms hingewiesen wird.

Um nicht von einem plötzlichen Senderwechsel mit einhergehendem Programminhaltswechsel überrascht zu werden, ist die Auslösung der alternativen Suche oft manuell vorgesehen.

Bei Autoradios mit Stationstasten sind den Stationstasten Speicherplätze zugeordnet, in denen Programmdaten abgespeichert werden können. Bei Betätigung einer Stationstaste werden die Programmdaten ausgelesen und der Rundfunkempfang auf ein den Daten entsprechendes Rundfunkprogramm abgestimmt. Im einfachsten Fall umfassen die Programmdaten eine bestimmte Rundfunkfrequenz. Bei Betätigung einer Stationstaste wird diese Rundfunkfrequenz und damit das Rundfunkprogramm, das über diese Rundfunkfrequenz ausgestrahlt wird, eingestellt.

Seit der Einführung von RDS werden Rundfunkprogramme, die von Rundfunksendern übertragen werden, Programmkennungen, sog. P(rogram) I(dentification) Codes, umkehrbar eindeutig zugeordnet. Bei modernen Autoradios kann unter einer Stationstaste als Programmdatum ein solcher PI-Code abgespeichert werden. Weiterhin ist es üblich, diesem PI-Code zugeordnet mindestens eine Rundfunkfrequenz zu speichern, über die dieses Rundfunkprogramm empfangen werden kann. Ergänzend können auch noch Listen alternativer Frequenzen für das Rundfunkprogramm, die ebenfalls über das RDS-Signal ausgestrahlt werden, gespeichert werden.

Diese Listen alternativer Frequenzen bzw. Rundfunkfrequenzen ermöglichen eine sogenannte AF-Best-Funktion bzw. Programm-Folge-Funktion, wobei der Rundfunkempfänger bei schlechter werdendem Empfang einer aktuell eingestellten Rundfunkfrequenz diese alternativen Rundfunkfrequenzen daraufhin prüfen kann, ob über sie ein besserer Empfang des gerade gehörten Rundfunkprogramms möglich ist. Dazu erfolgt eine kurzzeitige probeweise Abstimmung auf die alternativen Rundfunkfrequenzen mit Empfangsqualitätsprüfung. Im Fall einer besser empfangbaren alternativen Rundfunkfrequenz wird diese anstelle der bisher eingestellten Rundfunkfrequenz eingestellt.

Zur Bereitstellung der AF-Best-Funktion wird fast jedes FM-Rundfunkprogramm heute im UKW-Band über mehrere Rundfunkfrequenzen übertragen, wobei durch diesen Frequenzmultiplex verschiedene Gebiete überlappend abgedeckt werden. Die AF-Best-Funktion prüft von Zeit zu Zeit die zu einer gerade eingestellten Rundfunkfrequenz alternativen Rundfunkfrequenzen daraufhin, ob über diese möglicherweise das aktuell wiedergegebene Rundfunkprogramm besser empfangbar ist, als über die gerade eingestellte Rundfunkfrequenz. Ist dies der Fall, kann auf die besser zu empfangende Rundfunkfrequenz umgeschaltet werden. Für die Durchführung der AF-Best-Funktion sind zu den Programmidentifikations-Codes (PI) unter jeder Stationstaste in einem Frequenzspeicher auch die Rundfunkfrequenzen gespeichert, über die das jeweilige Programm ausgestrahlt wird. Eine Liste dieser sogenannten alternativen Frequenzen wird in Form einer AF-Liste über das RDS-Signal ausgestrahlt und kann im Rundfunkempfänger und somit Rundfunkempfangsgerät gespeichert werden. Die AF-Best-Funktion schließt bevorzugt auch eine Prüfung der Programmkennung ein, um sicherzustellen, dass eine alternative Frequenz auch tatsächlich das gerade eingestellte Programm ausstrahlt.

### Offenbarung der Erfindung

Bei dem erfindungsgemäßen Verfahren zum Einstellen eines Rundfunkprogramms für ein sich bewegendes Rundfunkempfangsgerät wird das Rundfunkprogramm ereignisabhängig in Abhängigkeit einer Situation aus der Vergangenheit automatisch eingestellt.

Bei einer Variante des Verfahrens zum Einstellen eines Rundfunkprogramms für ein sich bewegendes Rundfunkempfangsgerät wird das Rundfunkprogramm in Abhängigkeit des Orts, an dem sich dieses Rundfunkempfangsgerät befindet, automatisch eingestellt.

Somit wird für das Rundfunkempfangsgerät bzw. für einen Rundfunkempfänger oder ein Radio ereignisabhängig, bspw. auch zeitabhängig, aus einer Anzahl mehrerer zur Auswahl stehender Rundfunkprogramme ein Rundfunkprogramm ausgewählt und eingestellt. Dabei wird berücksichtigt, an welchem Ort sich dieses Rundfunkempfangsgerät befindet. Ein Einstellen und/oder eine Auswahl des Rundfunkprogramms erfolgt dabei u. a. zeitabhängig, wobei ein automatisches Umschalten erfolgt.

Dies erfolgt in der Regel dann, wenn sich die Empfangsqualität eines aktuell eingestellten Programms, das von einem Rundfunksender bereitgestellt wird, in Abhängigkeit des Orts verschlechtert. Hierzu kann vorgesehen sein, dass berücksichtigt wird, auf welcher Frequenz bzw. Rundfunk- oder Sendefrequenz ein zu empfangendes und somit einzustellendes Rundfunkprogramm oder ein entsprechendes Signal für dieses Rundfunkprogramm von einer Sendeeinrichtung ausgestrahlt wird. Demnach wird in Ausgestaltung unter anderem auch berücksichtigt, dass sich die Empfangsqualität des aktuell eingestellten Rundfunkprogramms bzw. Programms ortsabhängig auf einer bestimmten Sendefrequenz verschlechtert, so dass beim Einstellen des neuen Rundfunkprogramms auch das bisherige, aktuell eingestellte oder ursprünglich eingestellte Rundfunkprogramm auf einer neuen Frequenz als das vorgesehene neue Rundfunkprogramm eingestellt werden kann. Demnach kann zum ereignisabhängigen Einstellen auch eine frequenzabhängige Empfangsqualität des Programms berücksichtigt werden. Eine Anwendung des Verfahrens bietet sich bspw. dann an, wenn das Rundfunkempfangsgerät bewegt wird, weil es bspw. in einem Fahrzeug installiert ist.

Bei Ausführung des Verfahrens wird eine Situation oder eine Einstellung aus der Vergangenheit, bei der sich das Rundfunkempfangsgerät bereits an dem Ort befand, berücksichtigt, so dass das Rundfunkprogramm in Abhängigkeit der Situation aus der Vergangenheit eingestellt wird. Folglich wird u. a. eine orts- und ggf. auch ereignisabhängige Voreinstellung aus der Vergangenheit als Kriterium zur Auswahl des Rundfunkprogramms genutzt. Somit werden Einstellungen von Rundfunkprogrammen, die in der Vergangenheit ortsabhängig vorgenommen wurden, berücksichtigt. Dies bietet sich an, wenn bestimmte Strecken mit einem Fahrzeug, in dem das Rundfunkempfangsgerät installiert ist, immer wieder abgefahren werden.

Außerdem können Empfangsqualitäten von zur Auswahl stehenden Rundfunkprogrammen berücksichtigt werden. Dies kann in Ausgestaltung bedeuten, dass die Empfangsqualitäten von mindestens zwei zur Auswahl stehenden Rundfunkprogrammen verglichen werden. Eine derartige Auswahl kann auch frequenzabhängig vorgenommen werden, so dass in Abhängigkeit des Orts, an dem sich das Rundfunkempfangsgerät befindet, das einzustellende Rundfunkprogramm auch anhand der Frequenz, mit der dieses Rundfunkprogramm ausgestrahlt wird, ausgewählt wird. Somit ist es möglich, dieses Programm auf der Sendefrequenz mit der besten Empfangsqualität einzustellen und somit zu empfangen.

Weiterhin kann im Rahmen des Verfahrens beim Einstellen des Rundfunkprogramms zusätzlich in Abhängigkeit einer Tageszeit und demnach zeitabhängig, an dem der Rundfunksender einzustellen ist, ausgewählt und folglich eingestellt werden. Bei Berücksichtigung der Tageszeit als ein weiteres Ereignis können Vorlieben seitens eines Nutzers des Rundfunkempfangsgeräts für bestimmte Sendungen, die von bestimmten Rundfunkprogrammen zu bestimmten Tageszeiten ausgestrahlt werden, berücksichtigt werden. Demnach kann das Einstellen des Programms zusätzlich auch anhand eines Inhalts der zur Auswahl stehenden Rundfunkprogramme erfolgen.

In einer mögliche Variante der Erfindung ist vorgesehen, dass das Einstellen und ein damit verbundenes Umstellen des Rundfunkprogramms ausgehend von dem Nutzer und somit in der Regel manuell oder durch eine andere geeignete Beaufschlagung des Rundfunkempfangsgeräts, bspw. durch Sprachsteuerung, vorgenommen wird. Ein derartiges manuelles Einstellen wird in der Regel dann vorgenommen, wenn sich die Empfangsqualität des aktuell eingestellten Programms typischerweise frequenzabhängig verschlechtert. Somit kann durch das Verfahren das manuelle Einstellen des Rundfunkprogramms automatisch unterstützt werden.

Eine aktuelle ortsabhängige Einstellung des Programms kann weiterhin in Abhängigkeit des Orts bspw. frequenzabhängig gespeichert werden. Somit kann bei einem späteren Befahren der Strecke auf die ortsabhängige Einstellung aus der Vergangenheit zurückgegriffen werden, falls ein Programm aktuell neu einzustellen ist. Bei Speicherung der Einstellung oder einer entsprechenden Situation zu einem Zeitpunkt in der Vergangenheit wird notwendigerweise nicht nur berücksichtigt, welches Programm an diesem Ort ereignisabhängig eingestellt ist. Es kann weiterhin berücksichtigt werden, welche anderen Programme an diesem Ort typischerweise frequenzabhängig mit welcher Empfangsqualität zu empfangen sind, so dass bei einer zukünftigen Auswahl eines Programms, die ggf. in Abhängigkeit der Empfangsqualität durchzuführen ist, zukünftige Empfangsqualitäten untereinander sowie unter Berücksichtigung gespeicherter Empfangsqualitäten mehrerer Rundfunkprogramme berücksichtigt werden.

Die Erfindung sieht weiterhin ein Rundfunkempfangsgerät vor, das zum Empfangen eines Rundfunkprogramms ausgebildet ist. Dieses Rundfunkempfangsgerät ist weiterhin dazu ausgebildet, das Rundfunkprogramm ereignisabhängig in Abhängigkeit einer Situation aus der Vergangenheit automatisch einzustellen.

Das Rundfunkempfangsgerät kann zudem dazu ausgebildet sein, das Rundfunkprogramm in Abhängigkeit eines Orts, an dem sich das Rundfunkempfangsgerät befindet, automatisch einzustellen. Somit wird ein mögliches Ereignis durch den Ort, an dem sich das Rundfunkempfangsgerät befindet und/oder bewegt, und in Abhängigkeit der Situation aus der Vergangenheit bestimmt. Ein weiteres Ereignis kann alternativ oder ergänzend durch eine Zeit bestimmt werden.

Das vorgestellte Rundfunkempfangsgerät ist typischerweise zur Anordnung in einem Fahrzeug geeignet und somit in einem derartigen Fahrzeug installiert. Außerdem ist das Rundfunkempfangsgerät zur Durchführung sämtlicher Schritte des beschriebenen Verfahrens ausgebildet.

Die Erfindung betrifft außerdem ein Computerprogramm mit Programmcodemitteln, um alle Schritte eines beschriebenen Verfahrens durchzuführen, wenn das Computerprogramm auf einem Computer oder einer entsprechenden Recheneinheit, insbesondere in einem Rundfunkempfangsgerät, ausgeführt wird.

Das erfindungsgemäße Computerprogramm mit Programmcodemitteln, die auf einem computerlesbaren Datenträger gespeichert sind, ist zum Durchführen aller Schritte eines vorgestellten Verfahrens geeignet, wenn das Computerprogramm auf einem Computer oder einer entsprechenden Recheneinheit, insbesondere in einem beschriebenen Rundfunkempfangsgerät, ausgeführt wird.

Mit dem Verfahren können Programmwechsel bspw. bei wiederholtem Befahren bekannter Strecken, automatisiert durchgeführt werden.

Typischerweise unterbundene Programmwechsel, wenn sich das Fahrzeug aus dem Empfangsbereich einer Senderkette bewegt und das Programm des Senders ins Rauschen kommt, sollen ereignisabhängig zugelassen werden. Der Nutzer wird den Programmwechsel üblicherweise nur akzeptieren, wenn er sicher ohne Schaukeleffekt und bewusst voreingestellt erfolgt, so dass aufgrund der Empfangqualitäten ein kurzfristiger Wechsel zwischen mehreren Programmen, die von unterschiedlichen Sendern ausgestrahlt werden, vermieden wird. So kann erwünscht sein, dass bei der täglichen Heimfahrt zu einer bestimmten Zeit immer ein bestimmtes Regionalprogramm eingestellt werden soll. Bei Fernfahrten dagegen sollen automatisch persönlich bevorzugte Programme der Region eingestellt werden.

Da die Empfangsqualität von vielen Faktoren abhängt und auch die Überlappung der Programme an den Empfangsgrenzen fließend ist und somit zwischen zwei bereitgestellten Programmen üblicherweise keine klare Trennung eines Empfangsbereichs vorhanden ist, kann eine automatische, qualitätsabhängige Umschaltung durch eine Strategie der Langfristbetrachtung eines Ausgangs- und des Zielsenders vorbereitet werden. Die mittlere abfallende und mittlere ansteigende Signalqualität und das Überschreiten einer absoluten Signalschwelle lässt den Wechsel zu, wenn das Überschreiten bspw. durch eine lineare Funktion dargestellt werden kann. Um zudem Schaukeleffekte zu vermeiden, werden ereignisabhängige Wechselstrategien bevorzugt. Neben dem positiven Ergebnis der Langfristbetrachtung kann ein Zusatzereignis eintreten und berücksichtigt werden.

Eine Initialisierung für einen Wechsel bzw. eine Einstellung des Programms kann durch eine feste Uhrzeit als ein Ereignis ausgelöst werden. Dabei ist vorgesehen, dass bei Fahrten, wie z. B. zur Arbeit oder bei Wochenendfahrten, der durch die Qualitätsbewertung eines Ausgangs- und Zielprogramm, die von einem Ausgangs- bzw. Zielsender ausgestrahlt werden, vorbereitete Wechsel abhängig von einer Uhrzeit ausgelöst wird. Diese Uhrzeit kann in eine Lernphase eingegeben und/oder gespeichert werden.

Bei Berücksichtigung einer Regionalisierung als weiteres Ereignis kann ebenfalls die Initialisierung des Wechsels erfolgen, nachdem sich eine Regionalkennung geändert hat. Diese Regionalkennung ist Bestandteil des PI-Codes, die sich bei regionalisierten Programmen ändert. Damit einhergehend werden in verschiedenen Regionen zumindest zeitweise verschiedene Programminhalte ausgestrahlt. In diesem Fall erfolgt ein Wechsel zum Lieblings-Regionalprogramm auf einem Regionalsender bei erfüllten Qualitätskriterien bzgl. Empfang und/oder Inhalt.

In Ausgestaltung wird als zusätzliches Ereignis bei der Initialisierung eine Ortung berücksichtigt. Die Ortung erfolgt bspw. durch Nutzung von GPS (Global Positioning System) oder einem anderen geeigneten Ortungssystem mit Hilfe eines Ortungsmoduls. In Verbindung mit einem Navigations- oder Ortungsmoduls kann bei einer Fernfahrt sehr genau, typischerweise punktgenau, von einem Programm zum nächsten gewechselt werden. So werden bei einer Fahrt von München nach Hamburg nacheinander die Programme von BR-HR-NDR-Radio HH, d. h. Bayrischer Rundfunk, Hessischer Rundfunk, Norddeutscher Rundfunk und Radio Hamburg, empfangen. Die Gefahr eines Rückwechsels und somit eines Schaukeleffekts ist dann üblicherweise ausgeschlossen, da das einem Standard-Stationstastenaufruf entspricht. Die Einbindung der Ortung ermöglicht weiterhin nach einem sog. kalten Standortwechsel bei einer Fahrt von A nach B ohne Rundfunkbetrieb die Einstellung eines bevorzugten Ortssenders.

Als weiteres Kriterium zur Initialisierung kann als in Betracht zu ziehendes Ereignis die Best-Programm-Funktion für ein bestes Programm, d. h. ein Wechsel zwischen Programmen der Stationstasten wahlweise neben der Best-Frequenz-Funktion für eine beste Frequenz ein- und ausschaltbar ausgeführt werden. Die Wahl des neuen Programms entspricht in diesem Fall einem Stationstasten-Aufruf und unterliegt bis zum Eintreten eines weiteren Sonderereignisses den sog. AF-Best-Mechanismen.

Bei einer Weiterbildung des Verfahrens wird berücksichtigt, dass es unter bestimmten Umständen zu unerwünschten Programmwechseln kommen kann, wenn nämlich bspw. durch Vorbeifahrt eines Lkws ein über aktuell empfangenes Programm abgeschattet wird und damit die Empfangsqualität kurzzeitig einbricht. Ist in dieser Situation das alternative Programm besser empfangbar, schaltet das Radio typischerweise auf dieses um, obwohl nach Vorbeifahrt an dem Lkw das ursprünglich gehörte Programm unter Umständen deutlich besser zu empfangen ist, als das nun neu eingestellte Programm. Um dem vorzubeugen, ist bei einer Weiterbildung der Erfindung vorgesehen, dass bei Absinken der Empfangsqualität des aktuell eingestellten von einem Rundfunksender ausgestrahlten Programms, alternativ bei einem manuellen Umschalten des Programms auf eine ereignisabhängige, bspw. für einen Ort und/oder diese Tageszeit bevorzugte Alternative, die Empfangsqualitäten anderer am aktuellen Standort empfangbarer Programme durch kurzzeitiges Umschalten auf diese bestimmt werden.

Die Empfangsqualitätswerte, im einfachsten Fall ist dies die Empfangsfeldstärke, werden gespeichert. Alternativ kann dies zusätzlich die RDS-Fehlerrate, Multipath usw. sein. Bei einem erneuten Befahren derselben Strecke erfolgt dasselbe Vorgehen, wobei nun die Empfangsqualitätswerte mit in der Vergangenheit gespeicherten Werten verglichen werden. Hierdurch kann in erster Näherung ermittelt werden, ob die Empfangsqualität des aktuell eingestellten Programms am gleichen Ort einbricht, wie bei der oder den zurückliegenden Fahrt/en. Es wird nur dann auf das andere Programm umgeschaltet, wenn der Qualitätseinbruch am gleichen Ort wie beim letzten Programmwechsel erfolgt. Auf diese Weise können zumindest zufällige Einflüsse auf den Programmwechsel, wie die oben genannte Vorbeifahrt an einem Lkw oder dergleichen, ausgeschlossen werden.

Ein Prinzip dieser Vorgehensweise besteht u.a. darin, bei einem ersten Befahren der Strecke, insbesondere bei einem manuellen Programmwechsel, Informationen über die Senderlandschaft am Ort des Programmwechsels zu bestimmen und zu speichern und für zukünftige Fahrten zu nutzen. Somit kann bei einem zukünftigen Befahren der Strecke ein automatischer Programmwechsel bei Vorhandensein der im wesentlichen gleichen Senderlandschaft in Abhängigkeit derselben Umschaltbedingung wie in der Vergangenheit durchgeführt werden.

Allerdings herrschen nur im Idealfall immer an genau einem bestimmten Ort diese bestimmten Empfangsverhältnisse, d. h. einen Ort durch die Empfangsbedingungen zu definieren, ist nicht immer möglich. Nichtsdestotrotz kann aber die Umschaltung an von den Empfangsbedingungen abhängigen Umschaltbedingungen festgelegt werden.

Da die Empfangsqualität und insbesondere die Empfangsfeldstärke in Abhängigkeit bspw. von Witterungsverhältnissen am gleichen Ort schwanken kann, ist bei der Beurteilung der Senderlandschaft, also zur Bestimmung der Empfangsqualitäten der an diesem Ort empfangbaren Programme, vorgesehen, dass nicht die Absolutwerte herangezogen werden, sondern die Empfangsqualitäten der Programme auf verschiedenen Sendern jeweils zueinander ins Verhältnis gesetzt werden. Ist bspw. das aktuelle Programm A eines Senders bei starker Bewölkung schlechter zu empfangen als bei klarem Himmel, ist dies auch für das weitere Programm B desselben oder eines anderen Senders zu erwarten. Es sind dann also bei Bewölkungen beide Programme schlechter empfangbar, wobei das Verhältnis der Empfangsqualitäten der beiden Programme am aktuellen Standort witterungsunabhängig ungefähr gleich bleibt.

Ergänzend kann die Programm- und Senderlandschaft, d.h. die im Empfänger für einen Zeitpunkt der Programmumschaltung gespeicherten Qualitätswerte der anderen am Standort empfangbaren Programme, im Laufe der folgenden Fahrten über dieselbe Strecke durch neue Messwerte aktualisiert werden. Beispielsweise können sich unterschiedliche Wetterlagen auf die gemessenen Feldstärkewerte auswirken, was durch wiederholte Messungen und entsprechende Aktualisierung der Messwerte im Speicher, insbesondere durch Versehen der Messwerte mit von den Messwertschwankungen abhängigen Toleranzbereichen, ausgeglichen werden kann.

Beim Zurücklegen größerer Fahrstrecken, z. B. bei Wochenend-Berufspendlern, kann ein Fahrzeug das Ausstrahlungsgebiet eines gewohnten von einem Rundfunksender ausgestrahlten Rundfunkprogramms verlassen. Das dabei vom Benutzer eingestellte Rundfunkprogramm kann dann oft nicht weiter gehört werden. Verlässt der Benutzer das Ausstrahlungsgebiet des aktuell eingestellten Rundfunkprogramms, kann er manuell, bspw. durch Betätigen einer anderen Stationstaste, ein anderes Rundfunkprogramm aufrufen, sofern dieses für den dann aktuellen Fahrzeugstandort unter einer der Stationstasten gespeichert ist.

In der Regel wird der Benutzer erst dann auf ein anderes Rundfunkprogramm umschalten, wenn die Empfangs- und Wiedergabequalität des ursprünglich gehörten Programms sehr schlecht wird. Oftmals wird sich der Benutzer dann aber schon länger im Ausstrahlungsgebiet eines anderen Rundfunkprogramms befinden, in dem jedoch auch ein guter Empfang dieses ursprünglichen Programms möglich ist. Dies ist darauf zurückzuführen, dass sich Ausstrahlungsgebiete verschiedener Rundfunkprogramme weitläufig überlappen, bspw. von Südwestrundfunk, Hessischem Rundfunk und Norddeutschem Rundfunk.

Somit ist die Erfindung auch dazu geeignet, den Benutzer bei der manuellen Einstellung eines neuen Rundfunkprogramms bei Verlassen des Ausstrahlungsgebiets des bisher bzw. ursprünglich eingestellten Rundfunkprogramms zu entlasten. Dabei soll der Benutzer insbesondere stets, d. h. an jedem Standort entlang seiner üblichen Fahrstrecke, ein von ihm bevorzugtes Rundfunkprogramm hören können, ohne dass hierfür manuelle Eingriffe nötig sind. Weiter wird gemäß einer vorteilhaften Ausführungsform der Erfindung gewährleistet, dass an jedem Fahrzeugstandort ein Rundfunkprogramm mit zumindest annehmbarer Empfangsqualität eingestellt wird.

Die Erfindung sieht in Ausgestaltung weiterhin vor, dass der Benutzer, der eine längere Fahrstrecke zum ersten Mal befährt, die er voraussichtlich wiederholt zurückliegen muss, am Ausgangspunkt ein bevorzugtes Rundfunkprogramm unter einer ersten Stationstaste abspeichert. Im Laufe der Fahrt wird sich der Empfang dieses Programms ggf. verschlechtern. Der Benutzer sucht sich nun ein am aktuellen Standort empfangbares zweites Programm, das seinen Vorstellungen am ehesten entspricht und speichert dieses unter einer zweiten Stationstaste. Verlässt der Benutzer auch den Ausstrahlungsbereich dieses Programms, kann analog ein drittes Programm unter einer dritten Stationstaste gespeichert werden usw. Diese vom Ort abhängige Folge bevorzugter Sender kann abgespeichert und bei einem erneuten Befahren der Strecke oder bei Aufenthalt im Bereich dieser Strecke auch richtungsabhängig und demnach bereits bei der Rückfahrt berücksichtigt werden.

In weiterer Ausgestaltung der Erfindung wird nun bei erneutem Befahren der Strecke (oder auf der Rückfahrt) die AF-Best-Funktion bzw. Programm-Folge-Funktion von der Prüfung alternativer Frequenzen auf die Prüfung alternativer Programme ausgedehnt. D.h. der Rundfunkempfänger prüft nun von Zeit zu Zeit, ob eines der unter den Stationstasten gespeicherten Programme besser empfangbar ist, als das aktuell eingestellte Rundfunkprogramm. Dazu wird die AF-Best-Funktion auf die Prüfung der Alternativfrequenzen der weiteren gespeicherten Programme ausgedehnt. Hat der Fahrzeugführer nun ein Programm des Westdeutschen Rundfunks eingestellt und fährt wieder in Richtung Baden-Württemberg, so prüft der Rundfunkempfänger nun im Rahmen der AF-Best-Funktion nicht nur die unter der dritten Stationstaste gespeicherten Rundfunkfrequenzen auf ihre Empfangsqualität, sondern darüber hinaus auch die Rundfunkfrequenzen der weiteren üblicherweise in der Vergangenheit gespeicherten Programme, hier also Programme des Hessischen und des Südwest-Rundfunks. Ist ein derartiges weiteres Programm auf einer anderen, geeigneten Frequenz besser zu empfangen, als es für die Frequenz des aktuell eingestellten Programms der Fall ist, wird auf dieses weitere Programm umgeschaltet.

Die AF-Best-Funktion wird von den alternativen Frequenzen zu einem bestimmten eingestellten Programm bzw. Rundfunkprogramm auf alternative Frequenzen mindestens eines weiteren, bevorzugten Programms erweitert. Wird der Empfang eines aktuell eingestellten Programms auf einem ersten Programmspeicher schlechter und bringt auch die Programm-Folge-Funktion keine entscheidende Besserung, wird die Programm-Folge-Funktion auf die alternativen Frequenzen eines weiteren, bevorzugten Programms auf einen zweiten Programmspeicher ausgedehnt und im Falle eines akzeptablen Empfangs des weiteren Programms dieses in der Folge eingestellt.

In einem Ausführungsbeispiel kann als Ausgangspunkt ein herkömmliches heutiges RDS-Autoradio mit Stationstasten und zugeordneten Stationsspeichern für Programmdaten, etwa PI-Codes und Rundfunkfrequenzen, über die das jeweilige Programm empfangbar ist, sowie mit einer AF-Best-Funktion genutzt werden.

Es kann sinnvoll sein, hier ebenfalls auch eine PI-Prüfung durchzuführen, d.h. es soll gewährleistet werden, dass über die geprüfte Rundfunkfrequenz auch tatsächlich das gewünschte Programm ausgestrahlt wird.

Auf diese Weise kann der Benutzer an jedem Standort einer wiederkehrenden Reise regelmäßig ein bevorzugtes Rundfunkprogramm mit annehmbarer oder zumindest bestmöglicher Empfangsqualität hören, wobei er von einer manuellen Abstimmung des Rundfunkempfängers entlastet wird.

Um ein schnelles Hin- und Herwechseln zwischen zwei oder mehr Programmen zu verhindern, kann die Umschaltung mit einer Hysterese oder Erinnerungsfunktion verbunden werden. Dazu kann bspw. ein Programm, von dem aus auf ein anderes umgeschaltet wird, zeitweilig als verboten markiert werden. Alternativ kann die Empfangsqualitätsbewertung mit der Hysterese beaufschlagt werden. Somit kann vermieden werden, dass von einem neu eingestellten Programm nicht wieder auf das bisher gehörte zurück geschaltet wird, da dann voraussichtlich bald wieder umgeschaltet werden muss.

Weitere Vorteile und Ausgestaltungen der Erfindung ergeben sich aus der Beschreibung und der beiliegenden Zeichnung.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Kurze Beschreibung der Zeichnungen

- Figur 1: zeigt in schematischer Darstellung eine erste Ausführungsform eines erfindungsgemäßen Rundfunkempfangsgeräts.
- Figur 2: zeigt in schematischer Darstellung eine zweite Ausführungsform eines in einem Fahrzeug angeordneten erfindungsgemäßen Rundfunkempfangsgeräts.

### Ausführungsform der Erfindung

Die Erfindung ist anhand von Ausführungsbeispielen in den Zeichnungen schematisch dargestellt und wird im folgenden unter Bezugnahme auf die Zeichnungen ausführlich beschrieben.

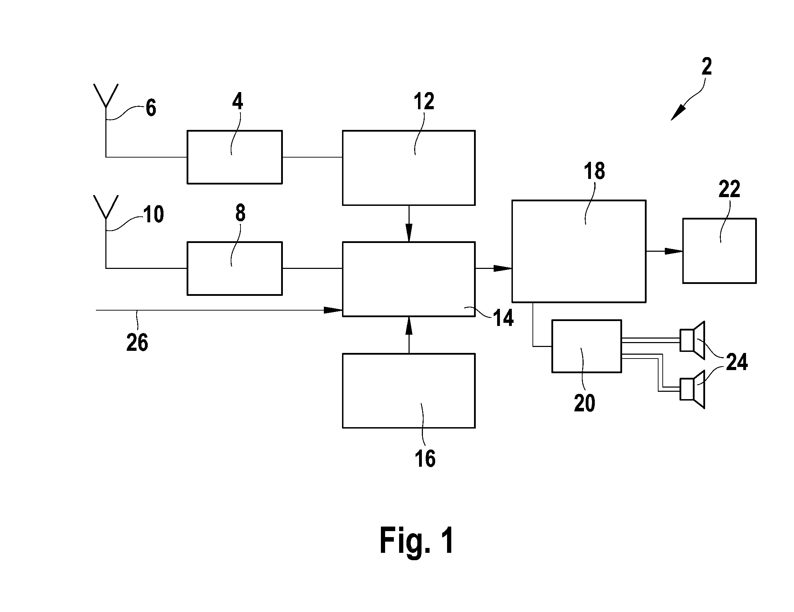

Die in Figur 1 dargestellte Ausführungsform des erfindungsgemäßen Rundfunkempfangsgeräts 2 umfasst einen Empfänger 4 bzw. einen Receiver, der mit einer Rundfunkempfangsantenne 6 verbunden ist. Außerdem umfasst das Rundfunkempfangsgerät 2 ein Ortungsmodul 8, das mit einer Ortungsantenne 10 verbunden ist. Das Rundfunkempfangsgerät 2 umfasst weiterhin ein Qualitätsbewertungsmodul 12, eine Schaltstufe 14, eine Uhr 16, einen Hauptmicrocontroller 18 (Main-µC) als Recheneinheit des Rundfunkempfangsgeräts 2, wobei dieser Hauptmicrocontroller 18 u.a. zur Bereitstellung einer RDS-Wechselstrategie ausgebildet ist. Zudem weist das Rundfunkempfangsgerät 2 einen NF (Niederfrequenz)-Steller 20, ein Anzeigefeld 22 (Display) sowie zwei Lautsprecher 24 auf.

Bei Betrieb des Rundfunkempfangsgeräts 2, das sich in vorliegender Ausführungsform in einem sich bewegenden Fahrzeug befindet, kann es vorkommen, dass an einem bestimmten Ort eine Empfangsqualität eines über die Rundfunkempfangsantenne 6 empfangenen Rundfunkprogramms sich in Abhängigkeit des Orts sowie in Abhängigkeit der Frequenz, auf der dieses Programm ausgestrahlt wird, verschlechtert, was durch Feststellen eines Rauschens durch das Qualitätsbewertungsmoduls 12 festgestellt wird.

Um dennoch einen guten Empfang zu gewährleisten, ist es in dieser Situation erforderlich, ein neues Rundfunkprogramm einzustellen und dabei ggf. das aktuelle, ursprünglich eingestellte Rundfunkprogramm zu wechseln. Ein derartiger Wechsel des Rundfunkprogramms kann jedoch auch einen Wechsel zu einer anderen Frequenz ein- und desselben Rundfunkprogramms, das von einem Rundfunksender ausgestrahlt wird, umfassen. Eine neue Auswahl eines Rundfunkprogramms erfolgt durch Bestimmung des aktuellen Orts bzw. einer aktuellen Position des Rundfunkempfangsgeräts 2 mit Hilfe des Ortungsmoduls 8. Dabei wird in vorliegender Ausführungsform ergänzend berücksichtigt, welches Programm auf welcher Sendefrequenz in einer Situation aus der Vergangenheit schon einmal eingestellt war, als sich das Rundfunkempfangsgerät zu einem früheren Zeitpunkt an demselben Ort befand. Als weitere Alternative ist es möglich, eine Ortungsinformation 26 aus einer Navigation zu nutzen.

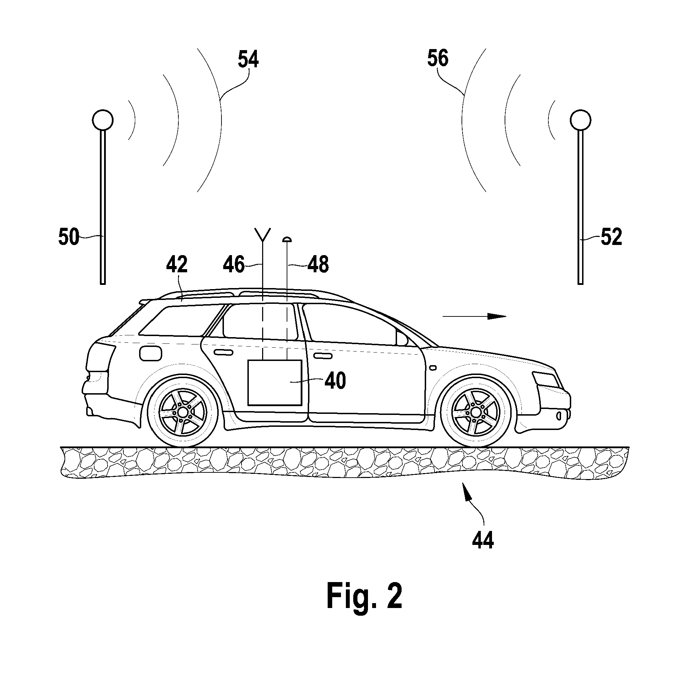

Figur 2 zeigt in schematischer Darstellung eine zweite Ausführungsform eines Rundfunkempfangsgeräts 40, das innerhalb eines sich bewegenden Fahrzeugs 42 angeordnet ist, wobei sich das Fahrzeug 42 an dem in Figur 2 gezeigten Ort 44 befindet. Das Rundfunkempfangsgerät 40 weist eine erste, als Rundfunkempfangsantenne 46 ausgebildete Antenne sowie eine zweite Antenne auf, die als Ortungsantenne 48 und somit zur Bestimmung des Orts 44 ausgebildet ist.

Über die Rundfunkempfangsantenne 46 ist es möglich, dass das Rundfunkempfangsgerät 40 ein Rundfunkprogramm, das von einer der beiden Sendeantennen 50, 52 aus Figur 2 über eine Sendefrequenz 54, 56 ausgestrahlt wird, empfängt.

In der vorliegenden Situation ist vorgesehen, dass das Rundfunkempfangsgerät 40 aktuell noch ein erstes Programm, das über eine erste Frequenz 54 von der ersten Rundfunkantenne 50 ausgestrahlt wird, empfängt. Allerdings hat sich eine vormals gute Empfangsqualität dieses ersten Rundfunkprogramms bei Erreichen des in Figur 2 gezeigten Ortes 44 verschlechtert, so dass seitens eines Nutzers des Rundfunkempfangsgeräts 40 und somit einem Fahrer des Fahrzeugs 42 eine Suche und somit eine Auswahl eines neuen Rundfunkprogramms in Erwägung gezogen wird. Hierzu wird u. a. die Empfangsqualität des ersten Rundfunkprogramms mit einer Empfangsqualität eines zweiten Rundfunkprogramms, das von der zweiten Senderantenne 52 über die zweite Sendefrequenz 56 ausgesendet wird, verglichen. Weiterhin wird das Einstellen des auszuwählenden Rundfunkprogramms in Abhängigkeit des Orts 44, der über die Ortungsantenne 48 unabhängig von Empfangsqualitäten der Rundfunkprogramme bestimmt wird, durchgeführt. Dabei wird im vorliegenden Beispiel berücksichtigt, welches Rundfunkprogramm zu einem vorherigen Zeitpunkt und somit in der Vergangenheit eingestellt war, als sich das Rundfunkempfangsgerät 40 innerhalb des Kraftfahrzeugs 42 an demselben Ort 44 befunden hat.

## Patentansprüche

1. Verfahren zum Einstellen eines Rundfunkprogramms für ein sich bewegendes Rundfunkempfangsgerät (2, 40), bei dem das Rundfunkprogramm ereignisabhängig in Abhängigkeit einer Situation aus der Vergangenheit automatisch eingestellt wird.

2. Verfahren nach Anspruch 1, bei dem das Rundfunkprogramm in Abhängigkeit des Orts (44), an dem sich das Rundfunkempfangsgerät (2, 40) befindet, automatisch eingestellt wird.

3. Verfahren nach Anspruch 1 oder 2, bei dem Empfangsqualitäten von mindestens zwei zur Auswahl stehenden Rundfunkprogrammen verglichen werden.

4. Verfahren nach einem der voranstehenden Ansprüche, bei dem das Rundfunkprogramm zusätzlich in Abhängigkeit einer Tageszeit eingestellt wird.

5. Verfahren nach einem der voranstehenden Ansprüche, bei dem das Rundfunkprogramm zusätzlich in Abhängigkeit eines Inhalts des Rundfunksenders eingestellt wird.

6. Verfahren nach einem der voranstehenden Ansprüche, das dazu geeignet ist, ein manuelles Einstellen des Rundfunkprogramms automatisch zu unterstützen.

7. Rundfunkempfangsgerät zum Empfangen eines Rundfunkprogramms, das dazu ausgebildet ist, das Rundfunkprogramm ereignisabhängig in Abhängigkeit einer Situation aus der Vergangenheit automatisch einzustellen.

8. Rundfunkempfangsgerät nach Anspruch 7, das zur Anordnung in einem Fahrzeug (42) geeignet ist.

9. Computerprogramm mit Programmcodemitteln, um alle Schritte eines Verfahrens nach einem der Ansprüche 1 bis 6 durchzuführen, wenn das Computerprogramm auf einem Computer oder einer entsprechenden Recheneinheit, insbesondere in einem Rundfunkempfangsgerät (2, 40) nach Anspruch 7 oder 8, ausgeführt wird.

10. Computerprogrammprodukt mit Programmcodemitteln, die auf einem computerlesbaren Datenträger gespeichert sind, um alle Schritte eines Verfahrens nach einem der Ansprüche 1 bis 6 durchzuführen, wenn das Computerprogramm auf einem Computer oder einer entsprechenden Recheneinheit, insbesondere in einem Rundfunkempfangsgerät (2, 40) nach Anspruch 7 oder 8, ausgeführt wird.
